# EUROPÄISCHE PATENTSCHRIFT

(11) **EP 0 968 631 B1**
(45) Veröffentlichungstag und Bekanntmachung des Hinweises auf die Patenterteilung: **28.11.2001**
(21) Anmeldenummer: 98914860.6
(22) Anmeldetag: 03.03.1998
(51) Int. Cl.: H05K 3/24

(54) **VERFAHREN ZUR BILDUNG METALLISCHER LEITERMUSTER AUF ELEKTRISCH ISOLIERENDEN UNTERLAGEN**
METHOD FOR FORMING METAL CONDUCTOR MODELS ON ELECTRICALLY INSULATING SUPPORTS
PROCEDE DE FORMATION DE CIRCUITS METALLIQUES CONDUCTEURS SUR DES SUPPORTS ELECTRIQUEMENT ISOLANTS

(30) Priorität: 11.03.1997 DE 19709954
(43) Veröffentlichungstag der Anmeldung: 05.01.2000
(73) Patentinhaber: Siemens S.A., 1060 Bruxelles (BE)
(72) Erfinder: HEERMAN, Marcel, B-9200 Merelbeke (BE); DE STEUR, Hubert, B-9031 Drongen (BE)
(74) Vertreter: Zedlitz, Peter, Dipl.-Inf.
(86) Internationale Anmeldenummer: EP9801188
(87) Internationale Veröffentlichungsnummer: WO9841070

(56) Entgegenhaltungen:
- EP-A- 0 370 133
- EP-A- 0 452 506
- EP-A- 0 517 399
- EP-A- 0 641 152
- WO-A-95/29573
- WO-A-96/09646
- US-A- 4 289 575
- PATENT ABSTRACTS OF JAPAN vol. 96, no. 10, 31.Oktober 1996 & JP 08 148809 A (POLYPLASTICS CO), 7.Juni 1996,
- PATENT ABSTRACTS OF JAPAN vol. 96, no. 10, 31.Oktober 1996 & JP 08 167769 A (POLYPLASTICS CO), 25.Juni 1996,

## Beschreibung

Verfahren zur Bildung metallischer Leitermuster auf elektrisch isolierenden Unterlagen.

Aus der US-A-4 804 615 ist ein Verfahren zur Bildung metallischer Leitermuster mit lötbaren Anschlußbereichen bekannt, bei welchem von einer beidseitig kupferkaschierten, elektrisch isolierenden ebenen Unterlage ausgegangen wird. Nach dem Bohren von Durchkontaktierungslöchern wird in einem chemischen Abscheidungsbad eine Kupferschicht abgeschieden, die sich auch über die Lochwandungen erstreckt. Auf diese Kupferschicht wird dann ein Galvanoresist aufgebracht, welcher nur die späteren Anschlußbereiche nicht bedeckt, so daß hier nacheinander Kupfer und eine Zinn-Blei-Legierung galvanisch abgeschieden werden können. Die Zinn-Blei-Legierung bildet dabei eine lötbare Endoberfläche der Anschlußbereiche. Nach der vollständigen Entfernung des Galvanoresists wird ein Ätzresist aufgebracht, welcher mit Ausnahme der Anschlußbereiche samtliche Bereiche des späteren Leitermusters bedeckt. Nachfolgend werden sämtliche, nicht dem Leitermuster entsprechenden Bereiche der chemisch abgeschiedenen Kupferschicht und der Kupferkaschierung bis zur Oberfläche der Unterlage abgeätzt. Bei diesem Ätzvorgang schützt nicht nur der eigentliche Ätzresist, sondern auch die ätzresistente Endoberfläche der Anschlußbereiche das darunterliegende Kupfer vor einem Ätzangriff. Nach der vollständigen Entfernung des Ätzresists wird dann ein Lötstopplack aufgebracht, welcher nur die lötbaren Anschlußbereiche des Leitermusters nicht bedeckt.

Aus der US-A-4 608 274 ist ein weiteres Verfahren zur Bildung metallischer Leitermuster mit lötbaren Anschlußbereichen bekannt, bei welchem von einer vorgebohrten, elektrisch isolierenden ebenen Unterlage ausgegangen wird. Nach der stromlosen Abscheidung von Kupfer auf beiden Seiten der Unterlage und in den Löchern, wird auf die Kupferschicht ein Ätzresist aufgebracht, welcher mit Ausnahme der späteren Anschlußbereiche alle Bereiche des späteren Leiterbildes bedeckt. Anschließend wird ein Galvanoresist aufgebracht, welcher nur die späteren Anschlußbereiche nicht bedeckt, so daß hier nacheinander Kupfer und eine Zinn-Blei-Legierung galvanisch abgeschieden werden können. Nach der vollständigen Entfernung des Galvanoresists werden säämtliche Bereiche der freiliegenden Kupferschicht bis zur Oberfläche der Unterlage abgeätzt, wobei im Bereich des Leitermusters der Ätzresist und die ätzresistente Endoberfläche der Anschlußbereiche die darunterliegende Kupferschicht vor einem Ätzangriff schützen. Nach der vollständigen Entfernung des Ätzresists werden auch wieder ein Lötstopplack aufgebracht, welcher nur die lötbaren Anschlußbereiche des Leitermusters nicht bedeckt.

Aus der WO 95/29573 ist ein weiteres Verfahren zur Bildung metallischer Leitermuster mit löt- und/oder bondbaren Anschlußbereichen auf elektrisch isolierenden Unterlagen bekannt. Dieses Verfahren umfaßt folgende Verfahrensschritte:
a.) Aufbringen einer Metallisierung auf die Unterlage;
b.) Aufbringen einer organischen, galvano- und ätzresistenten Schutzschicht auf die Metallisierung in einem Elektrotauchbad;
c.) Entfernen der Schutzschicht in den späteren Anschlußbereichen mittels Laserstrahlung;
d.) Galvanische Abscheidung einer ätzresistenten, lötund/oder bondbaren Endoberfläche auf die im Verfahrensschritt c) freigelegten Bereiche der Metallisierung;
e.) Entfernen der Schutzschicht zumindest in den unmittelbar an das spätere Leitermuster angrenzenden Bereichen mittels Laserstrahlung;
f.) Abätzen der im Verfahrensschritt e) freigelegten Bereiche der Metallisierung bis zur Oberfläche der Unterlage.

Die Vorteile des vorstehend geschilderten Verfahrens bestehen insbesondere darin, daß nur eine einzige organische Schutzschicht in einem Elektrotauchbad aufgebracht werden muß, die nach einer ersten Strukturierung mittels Laserstrahlung als Galvanoresist und nach einer zweiten Strukturierung mittels Laserstrahlung als Ätzresist dient und auch nach der Bildung des Leitermusters nicht entfernt werden muß. Die zuvor bereits als Galvanoresist und Ätzresist eingesetzte Schutzschicht kann gegebenenfalls zusätzlich auch noch als Lötstoppmaske verwendet werden.

In der WO 96/09646 wird ein sogenanntes Polymer Stud Grid Array (PSGA) beschrieben, welches die Vorteile eines Ball Grid Arrays (BGA) mit den Vorteilen der MID Technologie vereinigt. Die Bezeichnung der neuen Bauform als Polymer Stud Grid Array (PSGA) erfolgte dabei in Anlehnung an das Ball Grid Array (BGA), wobei der Begriff "Polymer Stud" auf beim Spritzgießen des Substrats mitgeformte Polymerhöcker hinweisen soll. Die neue für Single-, Few- oder Multi-Chip-Module geeignete Bauform umfaßt
- ein spritzgegossenes, dreidimensionales Substrat aus einem elektrisch isolierenden Polymer,
- auf der Unterseite des Substrats flächig angeordnete und beim Spritzgießen mitgeformte Polymerhöcker,
- auf den Polymerhöckern durch eine lötbare Endoberfläche gebildete Außenanschlüsse,
- zumindest auf der Unterseite des Substrats ausgebildete Leiterzüge, die die Außenanschlüsse mit Innenanschlussen verbinden und
- mindestens einen auf dem Substrat angeordneten Chip, dessen Anschlüsse mit den Innenanschlüssen elektrisch leitend verbunden sind.

Aus der US-A-4 289 575 ist ein Verfahren zur Herstellung gedruckter Schaltungen bekannt, bei welchem zunächst mittels konventioneller Fotoätztechnik ein Leitermuster erzeugt wird, dessen einzelne Leiter über Verbindungsstege miteinander verbunden bleiben. Anschließend wird ein elektrisch isolierender, galvano- und ätzresistenter erster Film derart aufgebracht, daß nur die Anschlußbereiche des Leitermusters und die Verbindungsstege freibleiben. Danach wird auf die Verbindungsstege ein galvanoresistenter zweiter Film aufgebracht, worauf auf die freiliegenden Anschlußbereiche des Leitermusters durch galvanische Metallabscheidung eine löt- und/oder bondbare Endoberfläche aufgebracht wird. Nach der Entfernung des zweiten Films können dann die Verbindungsstege selektiv abgeätzt werden.

Der in dem Anspruch 1 angegebenen Erfindung liegt das Problem zugrunde, ein einfaches und wirtschaftliches Verfahren zur Bildung metallischer Leitermuster mit löt- und/oder bondbaren Anschlußbereichen auf elektrisch isolierenden Unterlagen zu schaffen, das insbesondere auch für die Herstellung von Flexschaltungen und Polymer Stud Grid Arrays (PSGA) geeignet ist. Im Hinblick auf die an moderne Chipverpackungen gestellten Anforderungen sollten dabei Leiterbilder mit äußerst feinen Strukturen auf den Unterlagen gebildet werden können.

Basis für die erfindungsgemäße Lösung ist die Laserfeinstrukturierung, die es möglich macht auf einer Bearbeitungsfläche von zum Beispiel 5 x 5 cm² Strukturen von ca. 40 µm Leiterbreite und 30 µm Isolationsabstand ohne Reinraumbedingungen zu realisieren. Eine sehr dichte einlagige Verdrahtung zwischen ein- oder mehrreihigen Chipanschlüssen und den mehrreihigen Leiterplattenanschlüssen kann hiermit realisiert werden.

Bevorzugte Ausgestaltungen der Erfindung gehen aus den Unteransprüchen hervor.

Ausführungsbeispiele der Erfindung sind in der Zeichnung dargestellt und werden im folgenden näher beschrieben.

Es zeigen
- Figur 1: bis Figur 8 in stark vereinfachter schematischer Darstellung verschiedene Verfahrensstadien bei der Bildung metallischer Leitermuster mit lötbaren Anschlußbereichen auf einer elektrisch isolierenden Unterlage,
- Figur 9: einen Schnitt durch eine als Folie ausgebildete Unterlage mit Anschlußbereichen auf gegenüberliegenden Seiten der Folie,
- Figur 10: ) einen Schnitt durch ein Polymer Stud Grid Array mit auf integralen Pölymerhöckern gebildeten Anschlußbereichen,
- Figur 11: ein Ausführungsbeispiel für eine elektrisch leitende Verbindung der einzelnen Leiter eines Leitermusters,
- Figur 12: ein erstes Ausführungsbeispiel einer Flexschaltung mit einseitig angeordneten Chipanschlüssen und
- Figur 13: ein zweites Ausführungsbeispiel einer Flexschaltung mit zweireihig angeordneten Chipanschlüssen.

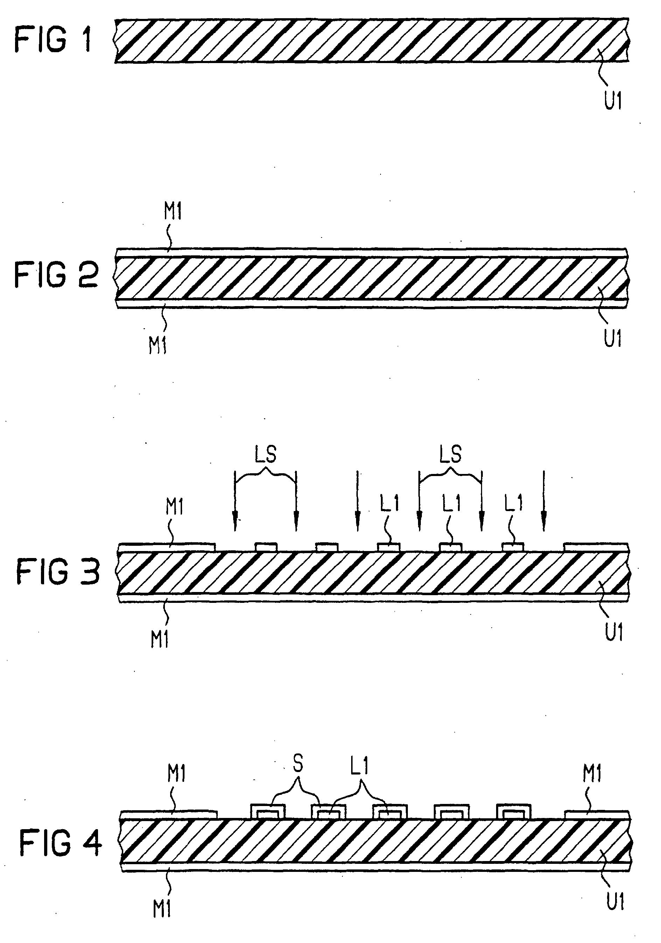

Gemäß Figur 1 wird von einer elektrisch isolierenden Unterlage U1 ausgegangen, bei welcher es sich im geschilderten Ausführungsbeispiel um eine dünne flexible Folie handelt.

Die in Figur 1 dargestellte Unterlage U1 wird zunächst zur Erhöhung der Haftfestigkeit des später aufzubringenden Leitermusters angeätzt und anschließend gereinigt. Nach der Reinigung erfolgt eine aus der Zeichnung nicht näher erkennbare Bekeimung der Unterlage U1, zum Beispiel durch Eintauchen in ein Pd-Cl₂-SnCl₂-Bad.

Nach einer Aktivierung der Bekeimung wird ganzflächig eine aus Figur 2 ersichtliche Metallisierung M1 auf die Unterlage U1 aufgebracht, wobei diese Metallisierung durch eine außenstromlos chemisch abgeschiedene Kupferschicht gebildet wird. Gegebenenfalls kann die Metallisierung M1 auch noch durch eine nachfolgende galvanische Kupferabscheidung verstärkt werden.

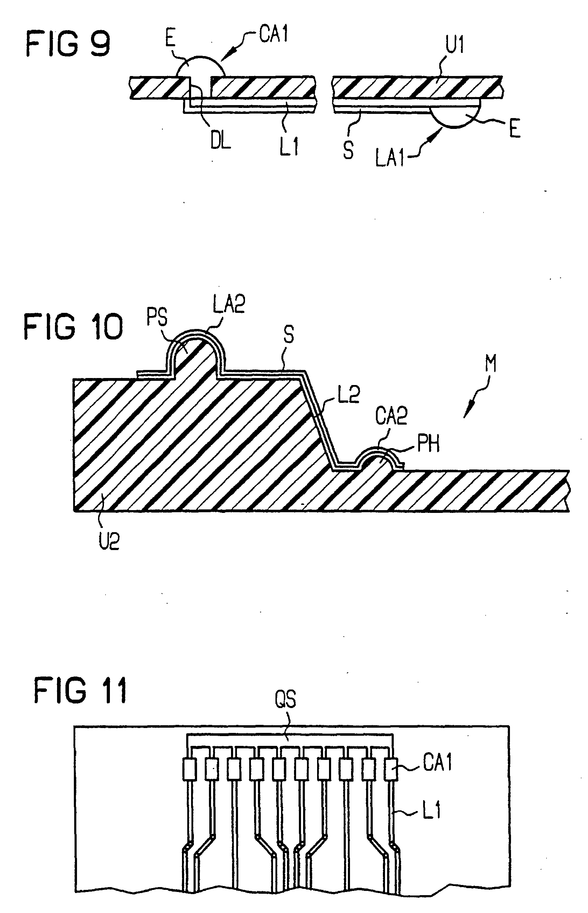

Gemäß Figur 3 wird anschließend die Metallisierung M1 mittels Laserstrahlung LS in den unmittelbar an das gewünschte Leitermuster angrenzenden Bereichen derart entfernt, daß die einzelnen Leiter L1 des Leitermusters elektrisch miteinander verbunden bleiben. Die in Figur 3 nicht erkennbare elektrisch leitende Verbindung der einzelnen Leiter L1 wird an späterer Stelle anhand der Figur 11 näher erläutert.

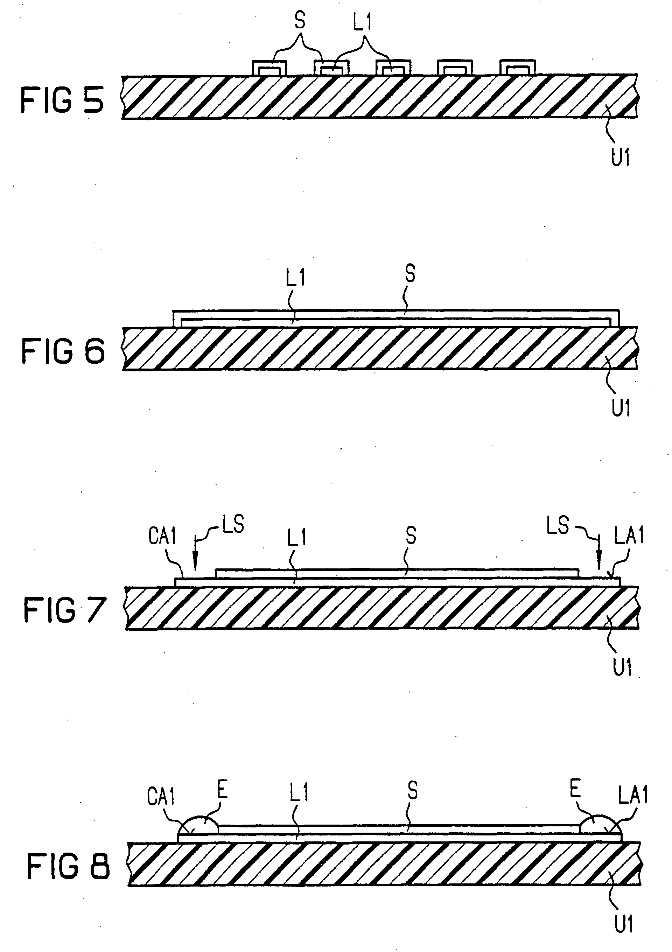

Gemäß Figur 4 wird anschließend in einem Elektrotauchbad eine organische, galvanoresistente Schutzschicht S auf das Leitermuster aufgebracht, wobei die elektrisch miteinander verbundenen Leiter L1 des Leitermusters je nach Art des Elektrotauchbades anodisch oder kathodisch kontaktiert werden.

Gemäß Figur 5 kann die Schutzschicht S auch als Ätzresist verwendet werden, wobei sämtliche nicht dem Leitermuster entsprechenden Bereiche der Metallisierung M1 in einem entsprechenden Ätzbad entfernt werden. Die nicht dem Leitermuster entsprechenden Bereiche der Metallisierung M1 können jedoch auch auf der Unterlage U1 verbleiben und später beispielsweise als elektromagnetische Abschirmung verwendet werden. Im letzteren Fall werden die verbleibenden Bereiche der Metallisierung M1 ebenfalls anodisch oder kathodisch kontaktiert und mit der Schutzschicht S überzogen.

Figur 6 zeigt in einem gegenüber Figur 5 um 90° verdrehten Schnitt durch die Unterlage U1 die Längserstreckung eines Leiters L1 und der darauf aufgebrachten Schutzschicht S.

Gemäß Figur 7 wird die Schutzschicht S nunmehr mittels Laserstrahlung LS in den späteren Anschlußbereichen des Leitermusters wieder entfernt. In Figur 7 ist dabei ein später als Chipanschluß zu verwendender Anschlußbereich CA1 und ein später als Leiterplattenanschluß zu verwendender Anschlußbereich LA1 erkennbar.

Auf die mittels Laserstrahlung LS freigelegten Bereiche des Leitermusters wird anschließend gemäß Figur 8 durch galvanische Metallabscheidung eine lötbare Endoberfläche E aufgebracht. Im dargestellten Ausführungsbeispiel handelt es sich bei dieser Endoberfläche E um eine Zinn-Blei-Legierung.

Figur 9 zeigt eine Variante, bei welcher die durch eine Flexfolie gebildete Unterlage U1 im Bereich der später als Chipanschlüsse dienenden Anschlußbereiche CA1 mit Durchkontaktierungslöchern DL versehen ist. Dadurch können auf der Unterseite der Unterlage U1 als Leiterplattenanschlüsse ausgebildete Anschlußbereiche LA1 und davon wegführende Leiter L1 angeordnet werden, während auf der Oberseite der Unterlage U1 die als Chipanschlüsse ausgebildeten Anschlußbereiche CA1 angeordnet werden. Dabei werden die als Chipanschlüsse ausgebildeten Anschlußbereiche CA1 durch die galvanische Abscheidung der lötbaren Endoberfläche E im Bereich der Durchkontaktierungslöcher DL aufgebaut.

Figur 10 zeigt ein weiteres Ausführungsbeispiel, bei welchem die anhand der Figuren 1 bis 8 geschilderten Verfahrensschritte bei der Herstellung eines Polymer Stud Grid Arrays angewendet werden. Hier wird eine dreidimensionale, durch Spritzgießen einer thermoplastischen Formmasse hergestellte Unterlage U2 verwendet, auf deren Unterseite beim Spritzgießen flächig angeordnete Polymerhöcker PS mitgeformt werden. Es ist ferner zu erkennen, daß auf der Unterseite der Unterlage U2 beim Spritzgießen auch eine Mulde M zur Aufnahme eines Chips geformt wird und daß im Bereich dieser Mulde M ebenfalls beim Spritzgießen Polymerhöcker PH mitgeformt werden. Auf diesen Polymerhöckern PH werden dann als Chipanschlüsse ausgebildete Anschlußbereiche CA2 erzeugt. Die Verbindung der als Leiterplattenanschlüsse ausgebildeten Anschlußbereiche LA2 und der als Chipanschlüsse ausgebildeten Anschlußbereiche CA2 erfolgt durch Leiter L2. Die Schutzschicht S bedeckt sämtliche Bereiche des Leiterbildes, die nicht den Anschlußbereichen LA2 und CA2 entsprechen.

Figur 11 zeigt ein Beispiel für die elektrisch leitende Verbindung der Leiter L1 des Leitermusters. Die Verbindung erfolgt hier durch einen Quersteg QS, der sämtliche als Chipanschlüsse ausgebildeten Anschlußbereiche CA1 miteinander verbindet. Dieser Quersteg QS wird dann beim Aufbringen der Schutzschicht S in einem Elektrotauchbad je nach Art des Bades anodisch oder kathodisch kontaktiert. Nach dem galvanischen Abscheiden der Endoberfläche kann der Quersteg beispielsweise durch Stanzen abgetrennt werden. Eine weitere einfache und wirtschaftliche Möglichkeit besteht darin, den Quersteg QS mittels Laserstrahlung von den zugehörigen Anschlußbereichen abzutrennen.

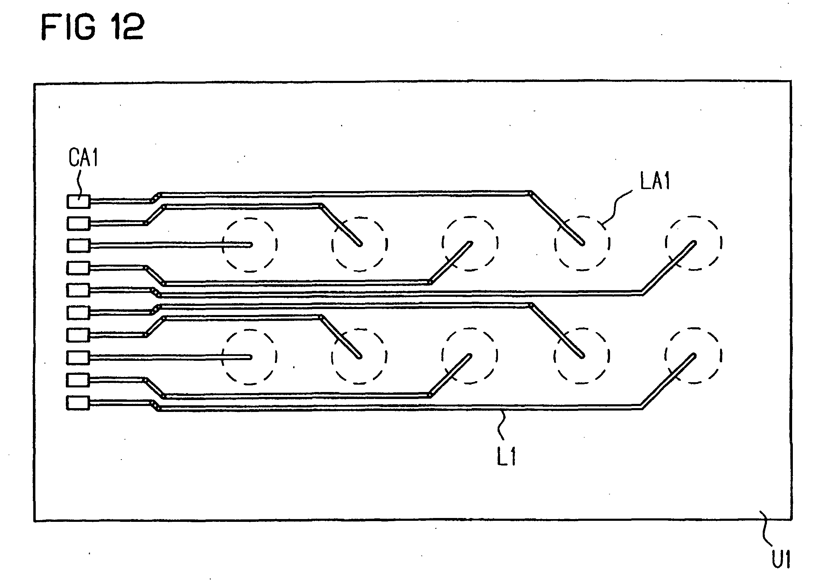

Figur 12 zeigt ein erstes Ausführungsbeispiel einer Flexschaltung, bei welcher die als Chipanschlüsse ausgebildeten Anschlußbereiche CA1 und die Leiter L1 auf einer Seite der Unterlage U1 gebildet werden. Die als Chipanschlüsse ausgebildeten Anschlußbereiche CA1 sind dabei in einer Reihe im Randbereich der Unterlage U1 angeordnet. Die als Leiterplattenanschlüsse ausgebildeten Anschlußbereiche LA1 sind in zwei Reihen auf der gegenüberliegenden Seite der Unterlage U1 angeordnet. Die Erzeugung dieser Leiterplattenanschlüsse erfolgt in Anlehnung an die in Zusammenhang mit Figur 9 beschriebene Vorgehensweise im Bereich von Durchkontaktierungslöchern, die jedoch in Figur 12 nicht näher dargestellt sind.

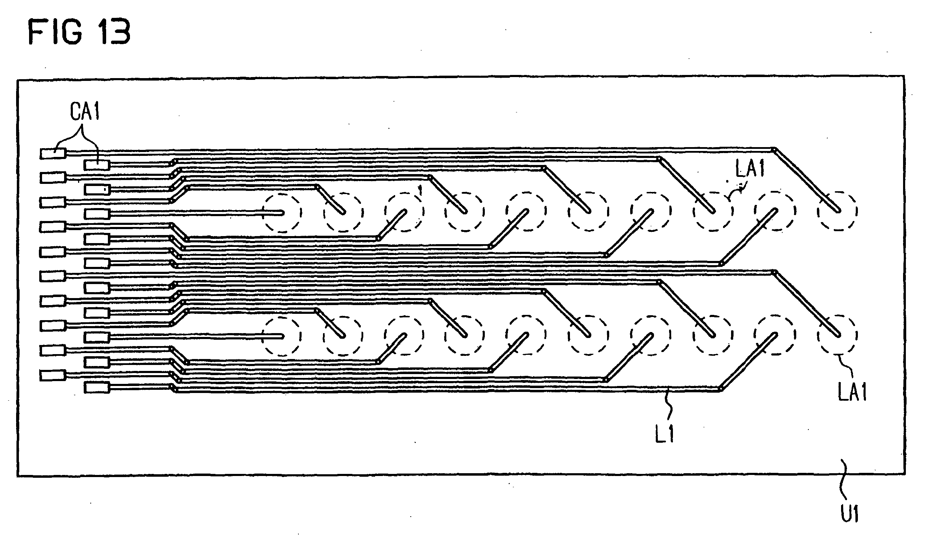

Figur 13 zeigt eine zweite Ausführungsform einer Flexschaltung, bei welcher im Unterschied zu der Ausführungsform gemäß Figur 12 zwei Reihen versetzt zueinander angeordneter als Chipanschlüsse ausgebildeter Anschlußbereiche CA1 vorgesehen sind. Durch diese versetzte Anordnung der Anschlußbereiche in zwei Reihen können zwischen den einzelnen Leitern L1 besonders geringe Isolationsabstände realisiert werden.

## Patentansprüche

1. Verfahren zur Bildung metallischer Leitermuster mit löt-und/oder bondbaren Anschlußbereichen (CA1, LA1; CA, LA2) auf elektrisch isolierenden Unterlagen (U1; U2), mit folgenden Verfahrensschritten:
a.) Aufbringen einer Metallisierung (M1; M2) auf die Unterlage (U1; U2)
b.) Entfernung der Metallisierung (M1; M2) mittels Laserfeinstrukturierung zumindest in den unmittelbar an das gewünschte Leitermuster angrenzenden Bereichen, derart, daß die einzelnen Leiter (L1; L2) des Leitermusters elektrisch miteinander verbunden bleiben;
c.) Aufbringen einer organischen, galvanoresistenten Schutzschicht (S) auf das Leitermuster in einem Elektrotauchbad;
d.) Entfernen der Schutzschicht (S) in den späteren Anschlußbereichen (CA1, LA1; CA2, LA2), durch Laserstrukturierung;
e.) Galvanische Abscheidung einer löt- und/oder bondbaren Endoberfläche (E) auf die im Verfahrensschritt d) freigelegten Bereiche der Metallisierung (M1; M2).

2. Verfahren nach Anspruch 1,
**dadurch gekennzeichnet,**
**daß** eine flexible Folie als Unterlage (U1) verwendet wird.

3. Verfahren nach Anspruch 2,
**dadurch gekennzeichnet,**
**daß** auf der Unterseite der Unterlage (U1) als Leiterplattenanschlüsse ausgebildete Anschlußbereiche (LA1) und davon wegführende Leiterzüge (LZ1) angeordnet werden, und daß auf der Oberseite der Unterlage (U1) als Chipanschlüsse ausgebildete Anschlußbereiche (CA1) angeordnet werden, wobei die als Chipanschlüsse ausgebildeten Anschlußbereiche (CA1) durch die galvanische Abscheidung der löt- und/oder bondbaren Endoberfläche (E) im Bereich von Durchkontaktierungslöchern (DL) aufgebaut werden.

4. Verfahren nach Anspruch 1,
**dadurch gekennzeichnet,**
**daß** eine dreidimensionale, durch Spritzgießen einer thermoplastischen Formmasse hergestellte Unterlage (U2) verwendet wird.

5. Verfahren nach Anspruch 4,
**dadurch gekennzeichnet,**
**daß** auf der Unterseite der Unterlage (U2) beim Spritzgießen flächig angeordnete Polymerhöcker (PS) mitgeformt werden und daß auf den Polymerhöckern (PS) als Leiterplattenanschlüsse ausgebildete Anschlußbereiche (LA2) erzeugt werden.

6. Verfahren nach Anspruch 5,
**dadurch gekennzeichnet,**
**daß** auf der Unterseite der Unterlage (U2) beim Spritzgießen eine Mulde (M) zur Aufnahme eines Chips geformt wird und daß die Polymerhöcker (PS) außerhalb des Muldenbereichs angeordnet werden.

7. Verfahren nach Anspruch 6,
**dadurch gekennzeichnet,**
**daß** im Bereich der Mulde (M) beim Spritzgießen Polymerhöcker (PH) mitgeformt werden und daß auf diesen Poylmerhöckern (PH) als Chipanschlüsse ausgebildete Anschlußbereiche (CA2) erzeugt werden.

8. Verfahren nach einem der vorhergehenden Ansprüche,
**dadurch gekennzeichnet,**
**daß** die Metallisierung (M1; M2) durch chemische Metallabscheidung auf die Unterlage (U1; U2) aufgebracht wird.

9. Verfahren nach Anspruch 8,
**dadurch gekennzeichnet,**
**daß** die Metallisierung (M1; M2) durch chemische Abscheidung von Kupfer hergestellt wird.

10. Verfahren nach Anspruch 8 oder 9,
**dadurch gekennzeichnet,**
**daß** die Metallisierung (M1; M2) vor oder nach ihrer Strukturierung im Verfahrensschritt b) durch galvanische Metallabscheidung verstärkt wird.

11. Verfahren nach Anspruch 10,
**dadurch gekennzeichnet,**
**daß** die Metallisierung (M1; M2) durch galvanische Abscheidung von Kupfer verstärkt wird.

12. Verfahren nach einem der vorhergehenden Ansprüche,
**dadurch gekennzeichnet,**
**daß** bei der Laserfeinstrukturierung Leiterbahnen mit einer Breite (b) von etwa 35 bis 45 µm und einem Isolationsabstand (a) von etwa 25 bis 35 µm erzeugt werden.

13. Verfahren nach einem der vorhergehenden Ansprüche,
**dadurch gekennzeichnet,**
**daß** die Metallisierung (M1; M2) ganzflächig auf die Unterlage (U1; U2) aufgebracht wird.

14. Verfahren nach Anspruch 1,
**dadurch gekennzeichnet,**
**daß** im Verfahrensschritt c) in dem Elektrotauchbad als Schutzschicht (S) ein temperaturbeständiger, als Lötstopplack geeigneter Lack auf das Leitermuster aufgebracht wird.

15. Verfahren nach Anspruch 14,
**dadurch gekennzeichnet,**
**daß** die Schutzschicht (S) nach dem Aufbringen auf das Leitermuster getrocknet wird.

16. Verfahren nach Anspruch 14 oder 15,
**dadurch gekennzeichnet,**
**daß** die nach der Strukturierung im Verfahrensschritt d) verbliebene Schutzschicht (S) ausgehärtet wird.

17. Verfahren nach einem der vorhergehenden Ansprüche,
**dadurch gekennzeichnet,**
**daß** im Verfahrensschritt c) des Anspruchs 1 oder im Verfahrensschritt e) des Anspruchs 2 als Endoberfläche (E) Zinn oder eine Zinn-Blei-Legierung abgeschieden wird.

18. Verfahren nach Anspruch 1 oder 2 oder nach einem der Ansprüche 3 bis 17,
**dadurch gekennzeichnet,**
**daß** im Verfahrensschritt c) des Anspruchs 1 oder im Verfahrensschritt e) des Anspruchs 2 als Endoberfläche (E) Nickel und Gold abgeschieden werden.

## Claims

1. Method for forming metallic conductor patterns having connection regions (CA, LA1; CA, LA2) that can be soldered and/or bonded on electrically insulating substrates (U1; U2), having the following method steps:
a.) applying a metallization (M1; M2) to the substrate (U1; U2)
b.) removing the metallization (M1; M2) by means of fine laser structuring, at least in those regions directly adjacent to the desired conductor pattern, in such a way that the individual conductors (L1; L2) of the conductor pattern remain electrically connected to one another;
c.) applying an organic, electrolysis-resistant protective layer (S) to the conductor pattern in an electrolytic dip-coating bath;
d.) removing the protective layer (S) in the subsequent connection regions (CA, LA1; CA2, LA2) by laser structuring;
e.) electrolytically depositing a final surface (E) that can be soldered and/or bonded to those regions of the metallization (M1; M2) exposed in method step d).

2. Method according to Claim 1, **characterized in that** a flexible sheet is used as the substrate (U1).

3. Method according to Claim 2 **characterized in that** connection regions (LA1) designed as printed circuit board connections and connector trains (LZ1) leading away from these are arranged on the underside of the substrate (U1), and **in that** connection regions (CA1) designed as chip connections are arranged on the upper side of the substrate (U1), the connection regions (CA1) designed as chip connections being built up by means of the electrolytic deposition of the final surface (E) which can be soldered and/or bonded in the region of through-contact holes (DL).

4. Method according to Claim 1, **characterized in that** use is made of a three-dimensional substrate (U2) produced by injection-moulding a thermoplastic moulding compound.

5. Method according to Claim 4, **characterized in that** polymer studs (PS) arranged over the area are formed on the underside of the substrate (U2) at the same time during the injection moulding, and **in that** connecting regions (LA2) designed as printed circuit board connections are produced on the polymer studs (PS).

6. Method according to Claim 5, **characterized in that** a trough (M) for accommodating a chip is formed on the underside of the substrate (U2) during the injection moulding, and **in that** the polymer studs (PS) are arranged outside the trough region.

7. Method according to Claim 6, **characterized in that** polymer studs (PH) are formed at the same time in the region of the trough (M) during the injection moulding, and **in that** connection regions (CA2) designed as chip connections are produced on these polymer stubs (PH).

8. Method according to one of the preceding claims, **characterized in that** the metallization (M1; M2) is applied to the substrate (U1; U2) by chemical metal deposition.

9. Method according to Claim 8, **characterized in that** the metallization (M1; M2) is produced by the chemical deposition of chopper.

10. Method according to Claim 8 or 9, **characterized in that** the metallization (M1; M2), before or after its structuring in method step b), is reinforced by electrolytic metal deposition.

11. Method according to Claim 10, **characterized in that** the metallization (M1; M2) is reinforced by the electrolytic deposition of copper.

12. Method according to one of the preceding claims, **characterized in that**, during the fine laser structuring, conductor tracks with a width (b) of about 35 to 45 µm and an insulation spacing (a) of about 25 to 35 µm are produced.

13. Method according to one of the preceding claims, **characterized in that** the metallization (M1; M2) is applied to the entire surface of the substrate (U1; U2).

14. Method according to Claim 1, **characterized in that**, in process step c) in the electrolytic dip-coating bath, a temperature-resistant lacquer suitable as a solder-stop lacquer is applied as a protective layer (S) to the conductor pattern.

15. Method according to Claim 14, **characterized in that** the protective layer (S) is dried after being applied to the conductor pattern.

16. Method according to Claim 14 or 15, **characterized in that** the protective layer (S) remaining after the structuring in method step d) is cured.

17. Method according to one of the preceding claims, **characterized in that** in method step c) of Claim 1 or in method step e) of Claim 2, tin or a tin/lead alloy is deposited as the final surface (E).

18. Method according to Claim 1 or 2 or according to one of Claims 3 to 17, **characterized in that** in method step c) of Claim 1 or in method step e) of Claim 2, nickel and gold are deposited as the final surface (E).

## Revendications

1. Procédé de formation de motifs métalliques conducteurs, ayant des zones (CA1, LA1 ; CA, LA2) de raccordement pouvant être brasées et/ou reliées, sur des supports (U1, U2) électriquement isolants comprenant les stades de procédés suivants :
(a) dépôt d'une métallisation (M1, M2) sur le support (U1, U2) ;
(b) élimination de la métallisation (M1, M2) au moyen d'une structuration fine par laser au moins dans les zones immédiatement adjacentes du motif conducteur souhaité, de façon que les conducteurs (L1, L2) individuels du motif conducteur restent reliés électriquement entre eux ;
(c) dépôt d'une couche (S) de protection organique galvanorésistante sur le motif conducteur dans un bain de dépôt par voie électrique ;
(d) élimination de la couche (S) de protection dans les zones (CA1, LA1, CA2, LA2) ultérieures de raccordement par structuration par laser ;
(e) dépôt galvanique d'une surface (E) finale pouvant être brasée et/ou reliée sur les zones de la métallisation (M1, M2) mises à nu dans le stade (d) du procédé.

2. Procédé selon la revendication 1, **caractérisé en ce qu'**il consiste à utiliser des feuilles souples comme support (U1).

3. Procédé selon la revendication 2, **caractérisé en ce qu'**il est disposé sur la face inférieure du support (U1) des zones (LA1) de raccordement constituées en forme de plaquettes à circuits imprimés et des pistes (LZ1) conductrices s'en éloignant et **en ce que** sur la face supérieure du support (U1) il est disposé des zones (CA1) de raccordement constituées en bornes de puce, les zones (CA1) de raccordement constituées en bornes de puce étant constituées par le dépôt galvanique de la surface (E) finale pouvant être brasée et/ou reliée dans la zone de trous (DL) métallisées.

4. Procédé suivant la revendication 1, **caractérisé en ce qu'**il consiste à utiliser un support (U2) tridimensionnel fabriqué par moulage par injection d'une matière à mouler thermoplastique.

5. Procédé suivant la revendication 4, **caractérisé en ce qu'**il est formé sur la face inférieure du support (U2) lors du moulage par injection des bossages (PS) en polymère disposés à plat et **en ce qu'**il est produit sur les bossages (PS) en polymère des zones (LA2) de raccordement constituées en bornes de circuit imprimé.

6. Procédé suivant la revendication 5, **caractérisé en ce qu'**il est formé sur la face inférieure du support (U2) lors du moulage par injection une cuvette (M) de réception d'une puce et **en ce que** les bossages (PS) en polymère sont disposés à l'extérieur de la zone de la cuvette.

7. Procédé suivant la revendication 6, **caractérisé en ce qu'**il est formé par la zone de la cuvette (M) lors du moulage par injection des bossages (PS) en polymère et **en ce qu'**il est produit sur ces bossages (PS) de polymère des zones (CA2) de raccordement constituées en bornes de puce.

8. Procédé suivant l'une des revendications précédentes, **caractérisé en ce qu'**il consiste à déposer la métallisation (M1, M2) par dépôt chimique de métal sur le support (U1, U2).

9. Procédé suivant la revendication 8, **caractérisé en ce qu'**il consiste à produire la métallisation (M1, M2) par dépôt chimique de cuivre.

10. Procédé suivant la revendication 8 ou 9, **caractérisé en ce qu'**il consiste à renforcer la métallisation (M1, M2) avant ou après sa structuration au stade (b) du procédé par dépôt de métal par électrolyse.

11. Procédé suivant la revendication 10, **caractérisé en ce qu'**il consiste à renforcer la métallisation (M1, M2) par dépôt de cuivre par électrolyse.

12. Procédé suivant l'une des revendications précédentes, **caractérisé en ce qu'**il consiste à produire lors de la structuration fine par laser des pistes conductrices d'une largeur (b) d'environ 35 à 45 µm et d'un intervalle (a) d'isolement d'environ 25 à 35 µm.

13. Procédé suivant l'une des revendications précédentes, **caractérisé en ce qu'**il consiste à déposer la métallisation (M1, M2) sur toute la surface sur le support (U1, U2).

14. Procédé suivant la revendication 1, **caractérisé en ce qu'**il consiste à déposer au stade (c) du procédé dans le bain de dépôt par voie électrique comme couche (S) de protection sur le motif conducteur un vernis qui résiste à la température et qui convient en tant que vernis d'arrêt de brasure.

15. Procédé suivant la revendication 14, **caractérisé en ce qu'**il consiste à sécher la couche (S) de protection après le dépôt sur le motif conducteur.

16. Procédé suivant la revendication 14 ou 15, **caractérisé en ce qu'**il consiste à durcir la couche (S) de protection qui reste après la structuration au stade (d) du procédé.

17. Procédé suivant l'une des revendications précédentes, **caractérisé en ce qu'**il consiste à déposer au stade (c) du procédé de la revendication 1 ou au stade (e) du procédé de la revendication 2, comme surface (E) finale de l'étain ou un alliage d'étain et de plomb.

18. Procédé suivant la revendication 1 ou 2 ou suivant l'une des revendications 3 à 17, **caractérisé en ce qu'**il consiste à déposer au stade (c) du procédé de la revendication 1 ou au stade (e) du procédé de la revendication 2, une surface (E) finale du nickel et de l'or.
